# EUROPÄISCHE PATENTSCHRIFT

(11) **EP 4 686 956 B1**
(45) Veröffentlichungstag und Bekanntmachung des Hinweises auf die Patenterteilung: **07.10.2026**
(21) Anmeldenummer: 24192414.1
(22) Anmeldetag: 01.08.2024
(51) Int. Cl.: G01R 31/54, G01R 31/58

(54) **VERFAHREN SOWIE PRÜFVORRICHTUNG ZUR PRÜFUNG EINES KABELSATZES**
METHOD AND TESTING DEVICE FOR TESTING A CABLE SET
PROCÉDÉ ET DISPOSITIF DE TEST POUR TESTER UN ENSEMBLE DE CÂBLES

(43) Veröffentlichungstag der Anmeldung: 04.02.2026
(73) Patentinhaber: LEONI Bordnetz-Systeme GmbH, 97318 Kitzingen (DE); LEONI Wiring Systems Slovakia spol. s r.o., 911 01 Trencin (SK)
(72) Erfinder: EGBERS, Andreas, 97340 Marktbreit (DE); KALIANKO, Imrich, 91101 Trencín (SK); RAHMAN, Mehbub-Ur, 97318 Kitzingen (DE); YEOLE, Aniket, 97318 Kitzingen (DE)
(74) Vertreter: FDST Patentanwälte

(56) Entgegenhaltungen:
- EP-A1- 4 336 201
- DE-A1- 10 315 743

## Beschreibung

Die Erfindung betrifft ein Verfahren sowie eine Prüfvorrichtung zur Prüfung eines Kabelsatzes.

Beim Kabelsatz handelt es sich insbesondere um einen Kabelsatz für ein Kraftfahrzeug, welcher also bei einem Bordnetz für ein solches Kraftfahrzeug eingesetzt wird. Kabelsätze werden regelmäßig auf ihre Funktionsfähigkeit hin überprüft. Eine solche Prüfung ist aufwendig, da die Kabelsätze eine Vielzahl von einzelnen Leitungen und damit Einzelverbindungen zwischen zwei Punkten aufweisen. Ein derartiger Kabelsatz kann beispielsweise bis zu 1000 oder auch mehr einzelne Leitungen und damit Einzelverbindungen aufweisen.

Zur Prüfung der Kabelsätze werden Prüfvorrichtungen eingesetzt, wie sie beispielsweise aus EP 4 336 201 A1 oder DE 10 315 743 A1 zu entnehmen sind, bei denen die Leitungsenden, beispielsweise mittels daran angebrachter Stecker, an einer Vielzahl von Prüfmodulen angeschlossen und mit deren Hilfe geprüft werden. Bei einer solchen Prüfung wird beispielsweise ein Prüfsignal auf das eine Leitungsende geschaltet und am anderen Leitungsende wird gemessen, ob das Signal ankommt.

Die Prüfung des gesamten Kabelsatzes erfolgt sukzessive gemäß einem vorgegebenen Prüfprogramm. Hierbei ist es wichtig, dass die die einzelnen Prüfmodule zueinander synchronisiert sind, sodass die einzelnen durch sie durchgeführten Prüfschritte abgestimmt zueinander durchgeführt werden.

Teilweise werden sogenannte Prüftische eingesetzt, die eine vorgegebene Geometrie und eine zentrale Prüfeinheit, auch Tester genannt, aufweisen. Die zentrale Prüfeinheit ist über Leitungen mit vorgegebenen Leitungslängen mit den Prüfmodulen verbunden. Durch diese festen Rahmenbedingungen ist eine schnelle und synchronisierte Prüfung ermöglicht.

Bei einer sogenannten dezentralen Prüfung, bei der die Prüfung innerhalb der Montagelinie für die Fertigung des Kabelsatzes erfolgt, ist eine derartige synchronisierte Prüfung jedoch nur mit speziellen Maßnahmen zu erreichen, da üblicherweise keine definierten Rahmenbedingungen bestehen. Das Prüfen innerhalb der Montagelinie wird angestrebt, um eventuelle Fehler direkt dort zu erkennen, wo sie entstehen und nicht beispielsweise erst am Ende der kompletten Kabelsatzfertigung.

Insbesondere bei einer derartigen dezentralen Prüfung werden häufig sogenannte intelligente Prüfmodule eingesetzt, welche selbst die Prüfung der Einzelleitungen steuern und beispielsweise Prüfsignalen erzeugen und/oder auswerten. Speziell bei einem derartigen Aufbau ist eine Synchronisation wichtig.

Für die Synchronisation können grundsätzlich Softwarelösungen oder auch hardwarebasierte Lösungen eingesetzt werden. Problematisch hierbei ist jedoch entweder ein hoher zeitlicher Aufwand, speziell bei einer Softwarelösung, bei der üblicherweise viele Datenpakete versendet werden müssen. Die für die Synchronisation erforderliche Zeit kann dabei aufgrund der sehr hohen Anzahl an einzelnen Verbindungen erheblich sein. Umgekehrt ist mit einer hardwarebasierten Lösung ein hoher Aufwand verbunden, was insgesamt zu hohen Kosten führt.

Ausgehend hiervon liegt der Erfindung die Aufgabe zugrunde, ein Verfahren sowie eine Prüfvorrichtung zum Prüfen eines Kabelsatzes anzugeben, wobei eine zügige Durchführung der Prüfung sowie einer Synchronisation der Prüfmodule mit geringem Aufwand ermöglicht ist.

Die Aufgabe wird gemäß der Erfindung gelöst durch ein Verfahren sowie eine Prüfvorrichtung zur Prüfung eines Kabelsatzes mit einer Vielzahl von Leitungen mit den Merkmalen des Anspruchs 1 bzw. mit den Merkmalen des Anspruchs 14. Die im Hinblick auf das Verfahren angeführten Vorteile und bevorzugten Ausgestaltungen sind sinngemäß auch auf die Prüfvorrichtung zu übertragen.

Die Prüfvorrichtung weist eine Prüfeinheit sowie mehrere Prüfmodule auf, mit deren Hilfe bei dem Verfahren die Prüfung durchgeführt wird. Die Prüfung erfolgt anhand eines vorgegebenen Prüfprogramms, welches mehrere aufeinanderfolgende Prüfsequenzen aufweist. Innerhalb einer jeweiligen Prüfsequenz werden von einem jeweiligen Prüfmodul durch das Prüfprogramm vorgegebene Prüfschritte durchgeführt. Um eine zuverlässige und korrekte Prüfung zu gewährleisten, werden die mehreren Prüfmodule miteinander synchronisiert, sodass sie also die ihnen im Rahmen des Prüfprogramms zugewiesenen Prüfschritte, die sie bei einer vorgegebenen Prüfsequenz ausführen sollen, zeitgleich, also innerhalb eines für die jeweilige Prüfsequenz vorgesehenen Zeitintervalls ausführen.

Für die gewünschte Synchronisation ist nunmehr vorgesehen, dass an der Prüfeinheit und an den Prüfmodulen, die gemeinsam Teilnehmer bilden, zum einen ein Steuersignal sowie zumindest ein Antwortsignal bei der Prüfung anliegt. Ein jeder Teilnehmer weist daher bevorzugt zumindest zwei Signaleingänge auf, wobei an dem einen das Steuersignal und einem anderen das Antwortsignal im Betrieb anliegt, ist zumindest zum Empfang der beiden Signale ausgebildet. Die Synchronisation und die Durchführung der Prüfung erfolgt dabei gemäß nachfolgenden Schritten. Die Prüfvorrichtung ist insgesamt dazu eingerichtet, die einzelnen Teilnehmer mit den beiden Signalen zu beaufschlagen, sodass also die beiden Signale verteilt an allen Teilnehmern anliegen. Weiterhin ist die Prüfvorrichtung zur Durchführung der folgenden Schritte ausgebildet:
a) Zum Starten einer Prüfsequenz wird von der Prüfeinheit das Steuersignal als ein Startsignal bereitgestellt, so dass das Startsignal an den Prüfmodulen anliegt. Über das Startsignal wird der Beginn der Prüfsequenz initialisiert und gestartet. Bei der Prüfeinheit handelt es sich insbesondere um eine eigenständige, von den übrigen Prüfmodulen getrennte Recheneinheit, beispielsweise ein separater Computer, welcher also kein Prüfmodul ausbildet und nicht an Leitungsenden des Kabelsatzes angeschlossen ist. Alternativ besteht grundsätzlich auch die Möglichkeit, dass die Funktionalität der Prüfeinheit in eines der Prüfmodule integriert ist, welches dann quasi als Master ausgebildet ist. Die jeweiligen Prüfmodule sind dabei vorzugsweise lediglich zum Lesen des Startsignals ausgebildet, können dieses also nicht verändern oder bearbeiten.
b) Sobald ein jeweiliges Prüfmodul das Startsignal empfängt, so veranlasst das jeweilige Prüfmodul, dass das zumindest eine Antwortsignal modifiziert wird, so dass an der Prüfeinheit ein modifiziertes Antwortsignal anliegt. Die Prüfmodule sind daher zur Modifizierung des Antwortsignals ausgebildet. Insbesondere wird ein Basissignal, welches im Normalzustand als Antwortsignal an den Teilnehmern anliegt, verändert.
c) Das jeweilige Prüfmodul führt anschließend den ihm in der jeweiligen Prüfsequenz zugeordneten Prüfschritt durch.
d) Nach der Durchführung des zugeordneten Prüfschritts veranlasst das jeweilige Prüfmodul eine erneute Modifikation des zumindest einen Antwortsignals. Speziell veranlasst das jeweilige Prüfmodul hierbei, dass das Antwortsignal wieder auf das Basissignal zurückgesetzt wird. Die Prüfeinheit überprüft das an ihr anliegende zumindest eine Antwortsignal dahingehend, ob alle Prüfmodule die erneute Modifikation des Antwortsignals veranlasst haben. Falls dies der Fall ist, so liegt an der Prüfeinheit das zumindest eine Antwortsignal als ein von dem ersten modifizierten Antwortsignal verschiedenes Antwortsignal an. Bevorzugt handelt es sich hierbei um das Basissignal.
e) Entsprechend bewertet die Prüfeinheit die Prüfsequenz als abgeschlossen, wenn alle Prüfmodule das Antwortsignal erneut modifiziert haben. Die Prüfeinheit erkennt also anhand des Signalzustandes des zumindest einen anliegenden Antwortsignals, ob alle Prüfmodule ihre Prüfung abgeschlossen haben, ob sie also die in der jeweiligen Prüfsequenz vorgesehenen Prüfschritte durchgeführt haben.
f) Ist dies der Fall, so startet die Prüfeinheit nachfolgend bevorzugt eine weitere Prüfsequenz, sofern eine solche im Prüfprogramm vorgesehen ist und stellt hierzu wieder ein Startsignal bereit. Für die weitere Prüfsequenz wird wieder gemäß den Schritten a) bis f) vorgegangen.

Dieser Ablauf mit den Schritten a) bis f) zur Durchführung einer jeweiligen Prüfsequenz wird schließlich bevorzugt solange wiederholt, bis sämtliche Prüfsequenzen des vorgegebenen Prüfprogramms ausgeführt sind.

Durch das hier beschriebene Verfahren ist eine besonders einfache synchrone Abarbeitung der einzelnen Prüfsequenzen und damit eine synchrone Durchführung der einzelnen Prüfschritte durch die verschiedenen Prüfmodule zuverlässig gewährleistet. Dies wird erreicht durch die beiden Signale, nämlich das Steuersignal und das Antwortsignal. Während das Steuersignal jeweils den Startzeitpunkt für eine erneute Prüfsequenz vorgibt, wird durch das zumindest eine Antwortsignal der Prüfeinheit mitgeteilt, ob bzw. bis wann sämtliche Prüfmodule mit der Abarbeitung des ihnen zugeordneten Prüfschrittes in der jeweiligen Prüfsequenz fertig sind. Erst dann wird durch die Prüfeinheit die nächste Prüfsequenz veranlasst. Hierdurch ist gewährleistet, dass die Prüfmodule synchron und damit zeitgleich die einzelnen Prüfsequenzen abarbeiten.

Unter Prüfsequenz wird vorliegend insbesondere die Summe aller einzelnen Prüfschritte verstanden, die von sämtlichen Prüfmodulen, innerhalb eines gleichen Zeitintervalls und damit gleichzeitig durchgeführt werden.

Das Zeitintervall ist insbesondere definiert durch die Zeitspanne zwischen dem Startsignal und dem Zeitpunkt, wenn alle Prüfmodule das Antwortsignal erneut modifiziert haben und die Prüfeinheit die Prüfsequenz als abgeschlossen wertet.

Während einer jeweiligen Prüfsequenz wird pro Prüfmodul an einer jeweiligen Leitung insbesondere nur eine einzige Prüfaktion durchgeführt. An einem Prüfmodul ist dabei eine Leitung oder es sind mehrere Leitungen angeschlossen. Bei mehreren Leitungen werden innerhalb einer Prüfsequenz vorzugsweise mehrere Leitungen parallel geprüft, indem an diesen mehreren Leitungen jeweils eine Prüfaktion durchgeführt wird.

Unter Prüfprogramm wird vorliegend insbesondere die Summe der aufeinanderfolgenden Prüfsequenzen verstanden, wobei innerhalb des Prüfprogramms Anweisung enthalten sind, welche Prüfschritte von welchen Prüfmodulen während einer jeweiligen Prüfsequenz ausgeführt werden.

Unter Prüfschritt wird vorliegend insbesondere die jeweilige von einem Prüfmodul während einer jeweiligen Prüfsequenz veranlasste zumindest eine Prüfaktion verstanden.

Prüfaktionen sind Aktionen, die das Prüfmodul an der am Prüfmodul angeschlossenen Leitung, bzw. bei mehreren am Prüfmodul angeschlossenen Leitungen an ausgewählten (insbesondere an allen) Leitungen durchführt, wobei die Auswahl der Leitungen typischerweise durch das Prüfprogramm vorgegeben wird. Prüfaktionen sind dabei insbesondere
- Einspeisen eines Prüfsignals in die zumindest eine ausgewählte Leitung,
- Auswerten eines an zumindest einer ausgewählten Leitung anliegenden Prüfsignals, welches z.B. von einem anderen Prüfmodul eingespeist wird,
- Kontrollaktion, ob die zumindest eine ausgewählte Leitung einen vorgegebenen Zustand einnimmt, speziell Kurzschlusskontrolle, insbesondere durch Messung eines Spannungswertes,
- Ruhe / Pausenaktion, d.h. an der zumindest einen ausgewählte Leitung ist nichts zu veranlassen.

Mithilfe der beiden erstgenannten Punkte (Einspeisen und Auswerten des Prüfsignals) wird jeweils die Kontinuität einer jeweiligen Leitung überprüft, speziell wird überprüft, ob zwischen zwei Endpunkten eine gewünschte Leitungsverbindung besteht.

Mithilfe der Kontrollaktion wird insbesondere überprüft, ob beispielsweise Schäden vorliegen, wie beispielsweise ein Kurzschluss. **In** einem solchen Fall würde z.B. in einer Leitung ein Signal erkennbar sein, auf die kein Prüfsignal aufgespielt wurde. Bei der Kontrollaktion wird daher insbesondere überprüft, ob an einer Leitung in unzulässiger Weise ein Signal anliegt.

Es handelt es sich vorliegend daher insofern um eine bidirektionale Synchronisation, indem in die eine Kommunikationsrichtung, und zwar von der Prüfeinheit zu den Prüfmodulen, jeweils der Start einer Prüfsequenz durch das Steuersignal initiiert wird. Umgekehrt wird durch die Modifikation des zumindest einen Antwortsignals von dem jeweiligen Prüfmodul an die Prüfeinheit das Ende der Prüfsequenz bekannt gemacht. Für die beiden Kommunikationsrichtungen und damit für das Steuersignal einerseits und das Antwortsignal andererseits sind zwei getrennte Kanäle ausgebildet. Die Übermittlung erfolgt bei einer drahtgebundenen Lösung vorzugsweise über zwei getrennte Leitungen, alternativ aber auch über nur eine einzige Leitung.

Bevorzugt wird vor dem Starten der Prüfsequenzen und damit vor dem Schritt a) entweder einmalig oder wiederholt vor jeder neuen Prüfsequenz eine Initialisierung veranlasst wird. Bei der Initialisierung werden die Prüfmodule quasi in Bereitschaft versetzt, um die Prüfung durchzuführen.

Die Initialisierung erfolgt insbesondere dadurch, dass die beiden Signale also das Steuersignal und das Antwortsignal an die Prüfmodule angelegt werden. Speziell wird hierbei an ihren Eingängen für das Steuersignal und das Antwortsignal jeweils ein Spannungssignal angelegt, wodurch die Initialisierung startet. Bei dieser werden beispielsweise erforderliche Vorbereitungen für die Durchführung der jeweiligen Prüfsequenzen bzw. der gesamten Prüfung ausgeführt. Das Anlegen der beiden Signale wird dabei insbesondere durch die Prüfeinheit veranlasst.

Vorzugsweise wird nach dem Schritt f) und vor dem Schritt g), also zwischen dem Ende und dem Start von aufeinanderfolgenden Prüfsequenzen, eine Deinitialisierung durchgeführt. Bei dieser werden die Prüfmodule insbesondere auf einen Ausgangszustand zurückgesetzt.

Hierzu wird von der zentralen Prüfeinheit bevorzugt als Steuersignal ein Reset-Signal abgegeben, woraufhin von den Prüfmodulen jeweils die Deinitialisierung gestartet und durchgeführt wird.

Zweckdienlicherweise werden die Schritte b) bis f) bei der Deinitialisierung analog durchgeführt, wobei anstelle einer Prüfsequenz eine Reset-Sequenz mit geeigneten Schritten für die Deinitialisierung ausgeführt wird. Die Signalbearbeitung sowie Signalmodifikation bei der Durchführung der Reset-Sequenz ist daher insbesondere identisch zu der bei der Prüfsequenz. Die Ansteuerung und Synchronisierung für die Durchführung der Prüfsequenz einerseits und Durchführung der Reset-Sequenz andererseits erfolgen daher in gleicher Weise. Die Signalabfolgen sind vorzugsweise identisch.

In bevorzugter Ausgestaltung handelt es sich bei dem Steuersignal und/oder dem Antwortsignal um ein digitales Signal. Hierfür können unterschiedliche digitale Signaltypen eingesetzt werden. Beispielsweise wird das Steuersignal, speziell das durch dieses gebildete Startsignal und / oder das Reset-Signal beispielsweise durch eine definierte Pulsfolge mit vorgegebener Pulsweite und/oder vorgegebener Pulsfrequenz gebildet. Hierzu können übliche Maßnahmen wie beispielsweise eine Pulsweitenmodulation usw. eingesetzt werden. Das Startsignal und das Reset-Signal unterscheiden sich vorzugsweise.

Gleiches gilt auch für das Antwortsignal. Die unterschiedlichen Modifikationen des Antwortsignals lassen sich daher beispielsweise anhand von unterschiedlichen Pulsfolge-Typen ausbilden.

Bevorzugt handelt es sich jedoch bei dem Steuersignal und/oder dem Antwortsignal um ein digitales Signal, welches lediglich zwischen zwei Signalpegeln wechselt (HIGH und LOW) und unterschiedliche Signalzustände ausschließlich durch den momentanen Signalpegel definiert wird. Auf die Dauer oder die Frequenz oder den zeitlichen Abstand von Pulsen einer Pulsfolge kommt es daher nicht an.

Insbesondere werden auch keine Datenpakete übertragen, wie dies beispielsweise bei herkömmlichen software-gestützten Lösungen der Fall ist.

Das vorzugsweise verwendete digitale Signal hat also u.A. die Vorteile, dass wenige und insbesondere keine Datenpakete benötigt und übermittelt werden. Speziell im Vergleich mit einer ggf. rein softwaretechnischen Lösung, bei der üblicherweise eine Vielzahl von Datenpaketen für eine Synchronisierung übermittelt werden, ist durch die vorgestellte Lösung eine relativ schnelle Synchronisierung ermöglicht.

Die oben beschriebene Initialisierung erfolgt also in einfacher Weise dadurch, dass an die beiden Kanäle der Prüfmodule (einmal für das Steuersignal und einmal für das Antwortsignal) jeweils ein definierter Signalpegel, insbesondere jeweils der Signalpegel **HIGH** angelegt wird.

Bevorzugt sind das Startsignal sowie das Reset-Signal durch unterschiedliche Signalpegel gebildet, d.h. die Prüfsequenz sowie die Reset-Sequenz werden jeweils durch ein Umschalten zwischen den Signalpegeln von **HIGH** zu LOW und umgekehrt initiiert.

Im Hinblick auf das Antwortsignal ist das oben erwähnte Basissignal daher durch einen Pegelzustand vorgegeben, insbesondere dem HIGH-Zustand, und dass modifizierte Antwortsignal ist durch den anderen Pegelzustand, insbesondere dem LOW-Zustand gegeben. Allgemein sind das modifizierte Antwortsignal sowie das erneut modifizierte Antwortsignal (insbesondere Basissignal) durch unterschiedliche Signalpegel gebildet.

Das Steuersignal und / oder das Antwortsignal liegen vorzugsweise kontinuierlich an den Teilnehmern an, d. h. entweder es liegt ein hoher Signalpegel oder ein niedriger Signalpegel dauerhaft an. Anhand einer Änderung des Signalpegels von **HIGH** zu LOW oder umgekehrt wird jeweils der Signalzustand verändert. Es erfolgt daher ein einfaches Umschalten durch Wechseln des Signalpegels.

Unter "Veranlassen einer Modifikation des Antwortsignals" durch die Prüfmodule wird insbesondere verstanden, dass ein jeweiliges Prüfmodul den Pegelzustand des anliegenden Antwortsignals ändert oder zumindest einen Schaltzustand wechselt. Insbesondere derart, dass im Falle eines anliegenden HIGH-Pegels dieser auf den LOW-Pegel geändert wird.

Bei einer Ausführungsform, bei der beispielsweise die einzelnen Prüfmodule im Hinblick auf das Antwortsignal seriell nacheinander angeordnet sind, besteht die Möglichkeit, dass durch das Umschalten eines vorhergehenden Prüfmoduls auf den LOW-Pegel an einem nachfolgenden Prüfmodul bereits lediglich der LOW-Pegel anliegt. In diesem Fall wird die Schalteinheit des nachfolgenden Prüfmoduls ebenfalls betätigt, allerdings hat dies dann keine Auswirkung auf den tatsächlich anliegenden Signalpegel. Dies bedeutet, dass bei Identifizierung des Startsignals ein jedes Prüfmodul den Schaltzustand einer solchen Schalteinheit von HIGH zu LOW ändert und erst wieder umschaltet, sobald der jeweilige Prüfschritt durchgeführt ist.

Insbesondere durch das zuvor beschriebene Verfahren, bei dem einfach zwischen zwei Schaltungszuständen umgeschaltet wird, um Zustandsänderungen zu signalisieren, erfolgt eine sehr einfache und zugleich zuverlässig Kommunikation zwischen den Teilnehmern.

Insgesamt ist daher für die Ansteuerung und Synchronisierung der Prüfmodule vorliegend gerade auf eine herkömmliche, üblicherweise komplexe Kommunikationsverbindung verzichtet, wie sie beispielsweise basierend auf einem vorgegebenen Kommunikationsprotokoll eines Bussystem (LIN, LAN, Ethernet usw.....) verwirklicht ist. Vielmehr kommunizieren die verschiedenen Teilnehmer einzig und allein im Hinblick auf das Steuersignal und/oder das Antwortsignal durch ein einfaches Umschalten zwischen zwei Pegelzuständen.

Die beiden zuvor beschriebenen Kommunikationskanäle, über die einerseits das Steuersignal und andererseits das Antwortsignal bereitgestellt werden, sind in bevorzugter Ausgestaltung durch zumindest zwei voneinander getrennte, physikalische Leitungen ausgebildet. Die Prüfeinheit ist hierbei über eine Steuerleitung sowie über zumindest eine und vorzugsweise genau eine Antwortleitung mit den Prüfmodulen verbunden, wobei über die Steuerleitung das Steuersignal und über die zumindest eine Antwortleitung das zumindest eine Antwortsignal bereitgestellt ist, also an den verschiedenen Teilnehmern anliegt. Bevorzugt liegt an diesen beiden Leitungen jeweils entweder ein HIGH-Pegel oder ein LOW-Pegel an.

Alternativ zu zwei getrennten physikalischen Leitungen ist - ggf. Abhängig von der Art der verwendeten Signale - nur eine einzige physikalische Leitung für die beiden Kommunikationskanäle eingesetzt.

In bevorzugter Ausgestaltung ist die zumindest eine Leitung und insbesondere sind beide Leitungen jeweils an jedem der Teilnehmer angeschlossen. Hervorzuheben ist hierbei, dass für das Antwortsignal sämtliche Teilnehmer bevorzugt über lediglich eine einzige Antwortleitung miteinander verbunden sind. Dies bedeutet, dass die einzelnen Prüfmodule nicht einzeln über jeweils eine individuelle Leitungsverbindung und damit beispielsweise sternförmig mit der Prüfeinheit verbunden sind. Hierdurch ist der Verdrahtungsaufwand gering gehalten.

Alternativ besteht auch die Möglichkeit, dass jedes Prüfmodul für das Antwortsignal individuell mit der Prüfeinheit über jeweils eine Antwortleitung verbunden ist, sodass insgesamt beispielsweise eine sternförmige Verbindung geschaffen ist.

Bevorzugt ist zwischen dem jeweiligen Prüfmodul einerseits und der Prüfeinheit andererseits jeweils nur eine physikalische Leitung sowohl für das Steuersignal als auch für das Antwortsignal ausgebildet.

Alternativ zu einer drahtgebundenen Kommunikationsverbindung besteht auch die Möglichkeit, einer drahtlosen Kommunikationsverbindung. In diesem Fall wird also das Steuersignal und/oder das zumindest eine Antwortsignal drahtlos beispielsweise über ein geeignetes Kommunikationsprotokoll zwischen der Prüfeinheit und den Prüfmodulen übermittelt.

Beispielsweise kommuniziert insbesondere bei einer drahtlosen Verbindung jedes Prüfmodul - vergleichbar mit der zuvor beschriebenen sternförmigen Verdrahtung - individuell mit der Prüfeinheit. Bei einer solchen (drahtlosen oder drahtgebunden) Kommunikationsverbindung erhält die Prüfeinheit beispielsweise von jedem der Prüfmodule jeweils ein Prüfmodul-spezifisches Antwortsignal. In einem solchen Fall überprüft die Prüfeinheit, ob von sämtlichen Prüfmodulen die erneute Modifikation des Antwortsignals als Indiz für die Beendigung der Prüfsequenz durchgeführt wurde. Eine neue Prüfsequenz wird von der Prüfeinheit also erst dann gestartet, wenn ihr von sämtlichen Prüfmodule das entsprechende erneut modifizierte Antwortsignal (insbesondere das Basissignal) vorliegt.

In bevorzugter Ausgestaltung wird für sämtliche Prüfmodule sowie für die zentrale Prüfeinheit lediglich eine gemeinsames Antwortsignal bereitgestellt, d. h. an allen Teilnehmern liegt jeweils gleichzeitig das gleiche Antwortsignal an. Bei den zuvor beschriebenen Umschalten zwischen den beiden Signalpegeln liegt daher bei allen Teilnehmern wahlweise entweder der HIGH-Pegel oder der LOW-Pegel an.

In zweckdienlicher Ausbildung sind die einzelnen Prüfmodule bezüglich des Antwortsignals seriell geschaltet. Bei dieser Variante ist lediglich eine Antwortleitung ausgebildet, über die die zentrale Prüfeinheit und die Prüfmodule miteinander verbunden sind. Diese Antwortleitung kann hierbei von jedem der Prüfmodule unterbrochen werden. Hierzu weist ein jedes Prüfmodul insbesondere eine geeignet ausgebildete Schalteinheit auf. Im Ausgangszustand liegt das Basissignal an, welches insbesondere durch den einen Pegelzustand, speziell durch den HIGH-Pegel gegeben ist. In diesem Fall ist die Antwortleitung nicht unterbrochen und beispielsweise sind sämtliche Schalteinheiten geschlossen. Die Antwortleitung ist insgesamt beispielsweise an einem positiven Bezugspotential angeschlossen. Zur Modifizierung des Antwortsignals und daher zum Umschalten des Spannungspegels insbesondere auf den LOW-Pegel reicht es aus, wenn eines der Prüfmodule die Antwortleitung unterbricht, d.h. wenn eine der Schalteinheiten die Antwortleitung von dem positiven Bezugspotential trennt. Hierdurch ist insgesamt ein sehr einfacher hardwaretechnischer Aufbau erreicht. Insbesondere wird durch diese Maßnahme zwischen dem Basissignal und dem modifizierten Antwortsignal hin und her geschaltet.

In zweckdienlicher Ausgestaltung wird in einem ersten Schritt vor Ausführung der ersten Prüfsequenz den Prüfmodulen das Prüfprogramm bekannt gemacht.

In bevorzugter Ausgestaltung weisen die Prüfmodule hierzu jeweils eine Steuereinheit auf, auf die das Prüfprogramm als Steuerprogramm aufgespielt wird und die zur Ausführung der im Steuerprogramm hinterlegten Schritte ausgebildet ist. Das Prüfprogramm wird den Prüfmodulen insbesondere über die zentrale Prüfeinheit mitgeteilt. Dies erfolgt beispielsweise über eine ggf. zusätzliche Kommunikationsverbindung, beispielsweise über eine herkömmliche Bus-Verbindung.

Bei dem Prüfprogramm handelt es sich insgesamt um eine Abfolge von vorgegebenen Steueranweisungen, die also Informationen enthalten, welche der Leitungen zu welchem Zeitpunkt in welcher Art und Weise geprüft werden muss. Die Steueranweisungen enthalten also detaillierte Informationen über die Abfolge der Prüfsequenzen und über die innerhalb einer jeweiligen Prüfsequenz von den individuellen Prüfmodulen durchzuführenden Prüfschritte mit den einzelnen Prüfaktionen.

Bei diesen Steueranweisungen handelt es sich daher insofern um ein Steuerprogramm, welches individuell auf die Prüfmodule aufgespielt wird. Dabei wird insbesondere auf jedes Prüfmodul das gleiche Steuerprogramm aufgespielt.

Es wird hierbei also insbesondere eine Software-Verteilung durchgeführt, um den einzelnen Prüfmodulen das jeweilige Prüfprogramm in Form eines Steuerprogramms bekanntzumachen.

**In** den Prüfmodulen ist bevorzugt ein Speicher angeordnet, auf dem das jeweilige Steuerprogramm abgelegt werden kann. **In** bevorzugter Ausgestaltung werden beispielsweise einem jeweiligen Prüfmodul mehrere Steuerprogramme für unterschiedliche Typen an Kabelsätzen übermittelt, die im Speicher gemeinsam abgelegt sind.

Für die Bekanntmachung des Prüfprogramms, welches für die aktuelle Prüfung des momentanen Kabelsatzes herangezogen werden muss, ergeht daher im einfachsten Fall eine Anweisung, welche der hinterlegten Steuerprogramme auszuführen ist.

Die Bekanntmachung des Prüfprogramms, also speziell das Aufspielen eines Steuerprogramms auf die Prüfmodule, erfolgt gemäß einer Ausführungsvariante dabei zwingend jeweils vor Ausführung der ersten Prüfsequenz. Dadurch ist sichergestellt, dass das richtige Prüfprogramm bei einem jeweiligen Kabelsatz durchgeführt wird. Beispielsweise wird zunächst identifiziert, welcher Typ Kabelsatz zur Prüfung ansteht, anschließend wird das diesem Typ Kabelsatz zugeordnetes Prüfprogramm ausgewählt und dem jeweiligen Prüfmodul bekannt gemacht. Bei Bedarf wird das entsprechende Steuerprogramm an das Prüfmodul übermittelt und diesem aufgespielt.

Alternativ kann auch vorgesehen sein, dass die Bekanntmachung des Prüfprogramms lediglich dann erfolgt, wenn der Typ des zu prüfenden Kabelsatzes sich ändert.

Insgesamt zeichnet sich das hier beschriebene Verfahren durch eine Kombination einer softwaregestützten sowie Hardware-gestützten Steuerung und Synchronisation der Prüfung des Kabelsatzes aus. Die Bekanntgabe des speziellen Prüfprogramms erfolgt also softwaregestützt, wohingegen im Laufe der Prüfung die Synchronisation durch das zuvor beschriebene Verfahren hardwaregestützt insbesondere durch die beschriebene Verdrahtung und den lediglich wechselnden Spannungspegeln erfolgt.

Ein weiterer Vorteil ist darin zu sehen, dass - beispielsweise aufgrund von unterschiedlichen Signallaufzeiten und / oder Leitungslängen oder sonstigen Einflüssen keine Wartezeiten vorgesehen und eingestellt werden müssen, wodurch eine schnelle Synchronisierung begünstigt wird.

Ein Ausführungsbeispiel der Erfindung wird nachfolgend im Zusammenhang mit den Figuren näher erläutert. Diese zeigen jeweils in vereinfachten Darstellungen:
- FIG 1: Eine Prüfvorrichtung zur Prüfung von Kabelsätzen mit einem schematisch dargestellten Kabelsatz,
- FIG 2: ein erstes Bespiel für eine mögliche Verdrahtung von Prüfmodulen mit einer zentralen Steuereinheit,
- FIG 3: ein zweites Beispiel für eine mögliche Verdrahtung von Prüfmodulen mit einer zentralen Steuereinheit, sowie
- FIG 4: ein Beispiel für eine mögliche Signalabfolge bei der Durchführung der Prüfung.

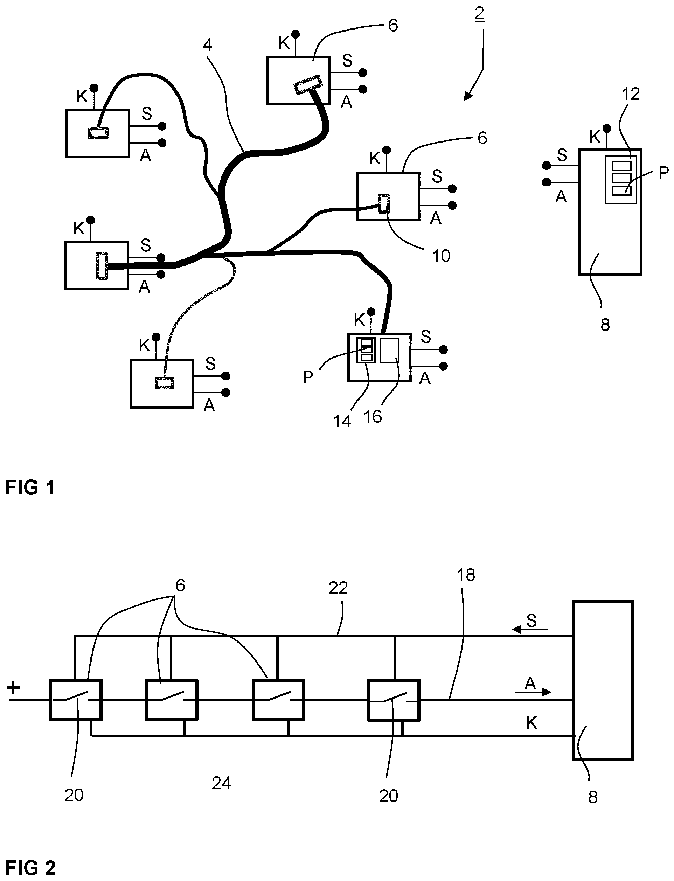

Eine in Figur 1 dargestellte Prüfvorrichtung 2 zur Prüfung eines Kabelsatzes 4 weist eine Vielzahl von Prüfmodulen 6 sowie eine zentrale Prüfeinheit 8 auf. Die zentrale Prüfeinheit 8 wird häufig auch Tester genannt. Der Kabelsatz 4 weist regelmäßig mehrere voneinander abzweigende Kabelstränge auf, die wiederum jeweils typischerweise mehrere einzelne elektrische Leitungen aufweisen. Häufig sind an diesen Kabelsträngen bereits Stecker 10 oder auch sonstige elektrische Einheiten, wie beispielsweise Aktoren, Sensoren oder Steuermodule angebracht.

Zur Prüfung der Funktionsfähigkeit des Kabelsatzes 4 werden üblicherweise sämtliche einzelne Leitungen des Kabelsatzes 4 im Hinblick auf ihren korrekten Anschluss und insbesondere auch im Hinblick auf die Durchgängigkeit überprüft. Dies erfolgt vorliegend vorzugsweise innerhalb einer Montagelinie bei der Kabelsatzfertigung, also dezentral. Für die Prüfung wird der Kabelsatz 4 an die verschiedenen Prüfmodule 6 angeschlossen. Bei diesen handelt es sich um intelligente Prüfmodule 6, welche selbst zur Durchführung der verschiedenen Prüfschritte und Prüfaktionen ausgebildet sind. Die verschiedenen Kabelstränge werden für die Prüfung hierzu jeweils an einem Prüfmodul 6 angeschlossen. Ein jeweiliges Prüfmodul 6 weist hierbei beispielsweise eine geeignete Steckeraufnahme für die Stecker 10 auf. Ein jeder Stecker 10 ist üblicherweise mit einer Vielzahl von Einzelleitungen belegt.

Ein derartiger Kabelsatz 4 weist regelmäßig eine sehr komplexe Struktur und eine Vielzahl von einzelnen Leitungen auf. Die Anzahl der Leitungen liegt typischerweise bei größer 100, häufig bei größer 500 und teilweise auch bei 1000 oder mehr. Üblicherweise wird jede einzelne Leitungsverbindung im Hinblick auf ihre Funktionsfähigkeit, also ihren korrekten Anschluss sowie Integrität überprüft.

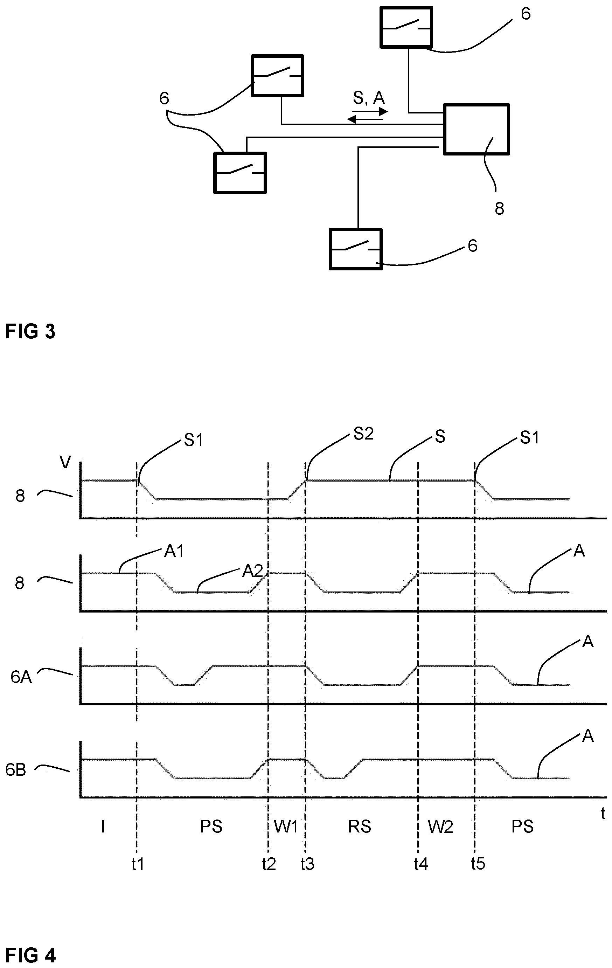

Aufgrund der Vielzahl der Leitungen erfolgt dies sukzessive in einer Abfolge von einzelnen Prüfsequenzen PS (vgl. FIG 4). Innerhalb einer jeweiligen Prüfsequenz PS führt jedes der Prüfmodule 6 vordefinierte Prüfschritte aus. Üblicherweise wird während einer Prüfsequenz PS an einer jeweiligen Leitung vorzugsweise genau eine Prüfaktion durchgeführt. Beispielsweise wird an einer ausgewählten Leitung, von einem der Prüfmodule 6 eine Prüfsignal angelegt bzw. es wird (quasi am anderen Ende durch ein weiteres Prüfmodul) als Prüfaktion eine Auswertung durchgeführt, ob das Prüfsignal auch tatsächlich anliegt. Daneben kann auch eine Kontrollaktion durchgeführt werden, die insbesondere überprüft, ob fälschlicherweise an einer ausgewählten Leitung ein Signal anliegt.

Die Durchführung der einzelnen Prüfaktionen der verschiedenen Prüfmodule 6 muss dabei abgestimmt und synchronisiert erfolgen, um beispielsweise an dem einen Prüfmodul 6 das Prüfsignal in eine bestimmte Leitung einzuspeisen und gleichzeitig am anderen Prüfmodul 6 zu überprüfen, ob das Prüfsignal ankommt.

Anhand eines vorliegend als Prüfprogramm P bezeichneten Steuerprogramms wird festgelegt, welche Prüfschritte und damit welche einzelnen Prüfaktionen innerhalb welcher Prüfsequenz von dem jeweiligen Prüfmodul 6 durchgeführt werden muss.

Für unterschiedliche Typen von Kabelsätzen 4 sind dabei unterschiedliche Prüfprogramme P vordefiniert. Diese sind im Ausführungsbeispiel in einem Speicher 12 der zentralen Prüfeinheit 8 hinterlegt. Bei diesen Prüfprogrammen P handelt es sich wie erwähnt um Steuerprogramme und daher um Software-Anwendungen.

Vor einer jeweiligen Prüfung eines jeweiligen Kabelsatzes 4 wird ein jeweiliges Kabelsatz-spezifisches Prüfprogramm P allen Prüfeinheiten 8 bekannt gemacht. Hierzu übermittelt beispielsweise die Prüfeinheit 8 das entsprechende Prüfprogramm P an sämtliche Prüfmodule 6, sodass sämtliche Prüfmodule 6 einheitlich das gleiche Prüfprogramm P verwenden.

Das Prüfprogramm P wird innerhalb eines Speichers 14 des jeweiligen Prüfmoduls 6 abgelegt. Bei Bedarf werden in dem Speicher 14 verschiedene Prüfprogramme P für unterschiedliche Typen von Kabelsätzen 4 abgelegt. Die Bekanntgabe des jeweils anzuwendenden Prüfprogramms P erfolgt dann beispielsweise auch einfach durch die Vorgabe, welches der Prüfprogramme P auszuwählen und auszuführen ist. Hierzu übermittelt die zentrale Prüfeinheit 8 beispielsweise ein geeignetes Auswahlsignal.

Für die Bekanntgabe des anzuwendenden Prüfprogramms P steht die zentrale Prüfeinheit 8 mit den verschiedenen Prüfmodulen 6 für einen Datenaustausch über eine Kommunikationsverbindung K in Verbindung. Hierzu ist insbesondere ein geeigneter Datenbus vorgesehen, über den die erforderlichen Daten übertragen werden. Die Kommunikationsverbindung K erfolgt beispielsweise drahtlos, bevorzugt jedoch drahtgebunden.

Bei der Prüfung werden entsprechend dem vorgegebenen Prüfprogramm P die erforderlichen und dem jeweiligen Prüfmodul 6 für eine jeweilige Prüfsequenz zugeordnete Prüfschritte ausgeführt. Die Prüfmodule 6 weisen hierzu eine Steuereinheit 16 auf, über die die verschiedenen Prüfschritte und Prüfaktionen veranlasst und durchgeführt werden. Die Ergebnisse der Prüfung werden beispielsweise wieder über die Kommunikationsverbindung K an die Prüfeinheit 8 übermittelt.

Für die Durchführung der Prüfung und zur Gewährleistung einer synchronen Abarbeitung der einzelnen Prüfsequenzen durch die verschiedenen Prüfmodule 6 erfolgt eine bidirektionale Synchronisation der Prüfmodule 6 mithilfe zweier Signale, nämlich einem Steuersignal S und einem Antwortsignal A. Diese beiden Signale S, A liegen parallel jeweils an allen Teilnehmern an, also an allen Prüfmodulen 6 sowie an der Prüfeinheit 8. Das Steuersignal S wird ausschließlich von der Prüfeinheit 8 vorgegeben und beeinflusst, wohingegen die Prüfmodule 6 lediglich zum Lesen des Steuersignals S vorgesehen und ausgebildet sind. Umgekehrt sind die Prüfmodule 6 zur Beeinflussung und Modifizierung des Antwortsignals A ausgebildet.

Allgemein wird anhand des Steuersignals S eine jeweilige Prüfsequenz gestartet. Durch Auswerten des Steuersignals S erfährt daher jedes der Prüfmodule 6, wann die nächste Prüfsequenz gemäß dem ausgewählten Prüfprogramm P gestartet werden muss.

Das Antwortsignal A dient allgemein zur Bekanntmachung für die Prüfeinheit 8, ob die Prüfmodule 6 die jeweiligen während der Prüfsequenz durchzuführenden Prüfschritte abgeschlossen haben. Hierzu wertet die Prüfeinheit 8 das Antwortsignal A aus.

Gleichzeitig wird das Antwortsignal A von einem jeden der Prüfmodule 6 modifiziert und beeinflusst, sobald das Prüfmodul 6 über das Steuersignal S über den Beginn der nächsten Prüfsequenz informiert wurde. Solange das Prüfmodul 6 die erforderlichen Prüfaktionen durchführt, bleibt das Antwortsignal A modifiziert. Nach Abschluss der erforderlichen Prüfaktionen wird die Modifizierung wieder zurückgesetzt, sodass das unmodifizierte Antwortsignal, vorliegend auch als Basissignal A1 bezeichnet, wieder an der zentralen Prüfeinheit 8 anliegt, sobald alle Prüfmodule 6 ihre Prüfaktionen beendet haben.

Anhand der Figur 2 ist eine beispielhafte Verdrahtung der Prüfmodule 6 mit der Prüfeinheit 8 dargestellt. Im Ausführungsbeispiel der Figur 2 sind die verschiedenen Prüfmodule 6 seriell an eine einzige, gemeinsame Antwortleitung 18 angeschlossen. Diese ist mit einem positiven Bezugspotential verbunden. Ein jeweiliges Prüfmodul 6 weist jeweils eine Schalteinheit 20 auf, durch die die Antwortleitung 18 unterbrochen werden kann.

Im normalen Zustand sind sämtliche Schalteinheiten 20 geschlossen, sodass an einem Eingang der zentralen Prüfeinheit 8, an dem das Antwortsignal A anliegt, ein positives Bezugspotential und damit ein hoher Spannungspegel anliegt. Hierdurch ist das normale Antwortsignal, also das Basissignal A1, definiert.

Das Steuersignal S wird über eine Steuerleitung 22 an die einzelnen Prüfmodule 6 übermittelt. Auch hierbei handelt es sich vorzugsweise um ein digitales Signal, welches zwischen den zwei Signalpegeln (Spannungswerten) umschaltet.

Sobald ein Startsignal S1, welches den Beginn einer neuen Prüfsequenz initiiert, von den Prüfmodulen 6 empfangen wird, veranlasst ein jedes der Prüfmodule 6 eine Modifizierung des ursprünglichen Ausgangssignals A (Basissignal A1). Hierzu öffnet ein jedes der Prüfmodule 6 einen Schalter der Schalteinheit 20, sodass die Antwortleitung 18 unterbrochen ist. Sobald und solange auch nur eine der Schalteinheiten 20 geöffnet ist, liegt am Eingang der Prüfeinheit 8 keine Spannung an (Signalpegel LOW), da die Antwortleitung 18 unterbrochen ist. Dies entspricht einem modifizierten Antwortsignal A2, wohingegen das ursprüngliche Basissignal A1 den hohen Signalpegel aufweist (vergleiche hierzu Figur 4).

Weiterhin ist anhand der Figur 2 zu erkennen, dass die einzelnen Prüfmodule über eine weitere Leitung, nämlich eine Kommunikationsleitung 24 mit der Prüfeinheit 8 verbunden sind.

Alternativ zu der in Figur 2 dargestellten seriellen Anordnung besteht auch die Möglichkeit, dass ein jedes der Prüfmodule 6 individuell mit der zentralen Prüfeinheit 6 jeweils über eine modulspezifische Antwortleitung verbunden ist, und dass gleichzeitig die Prüfeinheit 8 entsprechend eine Vielzahl von Eingängen für modulspezifischen Antwortsignale A aufweist. Eine solche Anordnung ist beispielhaft in Figur 3 dargestellt. Die einzelnen Prüfmodule 6 sind quasi sternförmig über zumindest eine physikalische Leitung an der zentralen Prüfeinheit 6 angeschlossen. Bevorzugt ist jedes Prüfmodul 6 über lediglich eine physikalische Leitung an der zentralen Prüfeinheit angeschlossen, über die also sowohl das Antwortsignal A als auch das Steuersignal S übermittelt werden. Alternativ sind die Prüfmodul6 6 jeweils über mehrere, insbesondere zwei Leitungen mit der Prüfeinheit 8 zur Übermittlung des Antwortsignals A und des Steuersignals S verbunden.

Anstelle einer Verdrahtung können einige oder alle der Signale S, A sowie die Kombinationsverbindung K auch drahtlos erfolgen. Bevorzugt ist jedoch insbesondere für das Steuersignal S und das Antwortsignal A eine drahtgebundene Leitung mit dem Wechsel zwischen den Signalpegeln vorgesehen, da hierdurch eine sehr einfache und robuste Ausgestaltung erreicht ist.

Eine mögliche Signalabfolge bei der Durchführung der Prüfung insbesondere zur synchronen Abarbeitung der verschiedenen Prüfsequenzen ist anhand der Figur 4 dargestellt: Diese zeigt mehrere Signalverläufe, bei denen jeweils der Signalpegel V (Spannungspegel) gegenüber der Zeit t aufgetragen ist.

Der oberste Signalverlauf zeigt dabei den Verlauf des Steuersignals S, wie er von der Prüfeinheit 8 abgegeben wird. Der zweite Signalverlauf von oben zeigt einen (resultierenden) Verlauf des Antwortsignals A, wie er an der Prüfeinheit 8 anliegt, bzw. von dieser ausgewertet wird.

Der dritte Signalverlauf von oben zeigt den Verlauf bzw. die Modifizierung des Antwortsignals A bei einem ersten Prüfmodul 6A und der unterste Signalverlauf zeigt den Verlauf bzw. die Modifizierung des Antwortsignals A bei einem weiteren Prüfmodul 6B. Wie zu erkennen ist, wechseln sämtliche Signalverläufe zwischen zwei Spannungspegel, nämlich zwischen einem **HIGH** - Pegel und einem LOW- Pegel.

Nachdem den einzelnen Prüfmodulen 6 das anzuwendende Prüfprogramm P bekannt gegeben wurde, startet die Prüfung des Kabelsatzes 4.

Hierzu erfolgt zunächst eine Initialisierung I und anschließend eine Abfolge von Prüfsequenzen PS und Reset-Sequenzen RS, bei denen jeweils die Prüfmodule 6 eine Deinitialisierung durchführen.

Für die Initialisierung I wird zunächst von der Prüfeinheit 8 an die beiden Leitungen 18, 22 ein hoher Spannungspegel angelegt. Dies wird von den Prüfmodulen 6 erkannt, die daraufhin die Initialisierung I durchführen.

Anschließend wird die erste Prüfsequenz PS ausgeführt. Hierzu wird von der Prüfeinheit 8 ein Startsignal S1 zum Zeitpunkt t1 abgegeben. Dies erfolgt durch Änderung des Signalpegels V, vorliegend durch Veränderung von **HIGH** zu LOW.

Das Ausgangssignal A befindet sich zunächst bei allen Teilnehmern 6, 8 auf dem hohen Signalpegel HIGH. Dieser Signalpegel definiert das Basissignal A1. Nach Erhalt der Startsignals S1 modifiziert jedes Prüfmodul 6A, 6B das Basissignal A1, sodass als modifiziertes Antwortsignal A2 ein niedriger Spannungspegel LOW anliegt.

Wie anhand eines Vergleichs der beiden Signalabfolgen für die beiden Prüfmodule 6A, 6B zu erkennen ist, braucht das weitere Prüfmodul 6B länger für die Ausführung der Prüfaktion und entsprechend liegt das modifizierte Antwortsignal A2 länger an. Die dargestellten Signalfolgen für das Antwortsignal A definieren beispielsweise bei der seriellen Anordnung gemäß FIG 2 ein Steuersignal für die Schalteinheit 20.

Allgemein definiert das zeitlich am längsten modifizierte Antwortsignal A2 den an der Prüfeinheit 8 anliegenden bzw. (bei einer Vielzahl von modulspezifischen Eingängen) resultierenden Signalpegel für das Antwortsignal A. Diese Situation ist anhand des zweiten Signalverlaufs von oben dargestellt. Bei einer Vielzahl von modulspezifischen Eingängen sind diese beispielsweise über UND-Gatter miteinander verknüpft, so dass ein resultierender Signalpegel **HIGH** nur dann vorliegt, wenn alle modulspezifischen Antwortsignale A wieder den Signalpegel **HIGH** eingenommen haben.

Sobald also das letzte Prüfmodul 6 wieder auf den hohen Spannungspegel und damit auf das Basissignal A1 umgeschaltet hat, wird dies entsprechend auch von der Prüfeinheit 8 so identifiziert, was als Beendigung der Prüfsequenz PS zu einem Zeitpunkt t2 gewertet wird.

Im Ausführungsbeispiel ist nach einer jeweiligen Prüfsequenz PS noch eine Deinitialisierung mit der Durchführung der Reset-Sequenz RS vorgesehen. Auf diese kann ggf. auch verzichtet werden.

Die Reset-Sequenz RS wird im Ausführungsbeispiel nach einer Wartezeit W1 zum Zeitpunkt t3 durch ein Reset-Signal S2 der Prüfeinheit 8 gestartet. Hierzu wechselt das Steuersignal S den Signalpegel von LOW wieder auf HIGH. Dies wird von den Prüfmodulen 6 erfasst. Diese beginnen daraufhin mit der Durchführung der erforderlichen Schritte für die Reset-Sequenz RS.

Während dieser Reset-Sequenz RS modifizieren die Prüfmodule 6 das Antwortsignal in gleicher Weise wie bei der Prüfsequenz PS. Erst wenn alle Prüfmodule 6 wieder auf das Basissignal A1 umgeschaltet haben, wertet die Prüfeinheit 8 dies als Ende der Reset-Sequenz RS zum Zeitpunkt t4.

Nach einer erneuten Wartezeit W2 wird dann schließlich die nächste Prüfsequenz PS initiiert, indem der Signalpegel wieder von HIGH auf LOW gewechselt wird und dadurch das Startsignal S1 zum Zeitpunkt t5 abgegeben wird.

Diese Abfolge wird so lange durchgeführt, bis sämtliche Prüfsequenzen PS abgearbeitet sind, die gemäß dem Prüfprogramm P vordefiniert sind.

Das hier beschriebene Verfahren zeichnet sich bei einem einfachen Aufbau durch eine zuverlässige und schnelle Synchronisierung aus. Bei dem beschriebenen Verfahren und der Vorrichtung wird das Steuersignal S von (genau) einem Master kontrolliert (Prüfeinheit 8). Dieses Steuersignal S geht zu allen anderen Teilnehmern, insbesondere den Prüfmodulen 6 und wird von diesen nur gelesen. Für stabile Signalpegel wird das Steuersignal S (und / oder das Antwortsignal A) beispielsweise zwischendurch noch verstärkt.

Das Antwortsignal A kann von allen Teilnehmern gesetzt / verändert und gelesen werden. Somit kann jeder Teilnehmer es verändern um mitzuteilen dass er fertig ist bzw. noch beschäftigt ist. Weiterhin ist dem jeweiligen Teilnehmer durch das Lesen des anliegenden Antwortsignals und dem Wissen um seinen eigenen Status bekannt, wann alle anderen Teilnehmer auch den gleichen Zustand haben wie er selbst.

Von besonderer Bedeutung ist, dass die Teilnehmer das gleiche Signal setzen / lesen können.

Bevorzugt wird eine drahtgebundene Lösung eingesetzt, bevorzugt eine Sternverdrahtung wie zu Figur 3 beschrieben.

Die vorgestellte Lösung zeichnet sich durch einfache Signale aus, wie dies beschrieben wurde. Es werden insbesondere keine komplexen Signalfolgen eingesetzt.

### Bezugszeichenliste

- 2: Prüfvorrichtung
- 4: Kabelsatz
- 6: Prüfmodul
- 8: zentrale Prüfeinheit
- 10: Stecker
- 12: Speicher der Prüfeinheit
- 14: Speicher des Prüfmoduls
- 16: Steuereinheit
- 18: Antwortleitung
- 20: Schalteinheit
- 22: Steuerleitung
- 24: Kommunikationsleitung

- P: Prüfprogramm
- K: Kommunikationsverbindung
- S: Steuersignal
- S1: Startsignal
- S2: Reset-Signal
- A: Antwortsignal
- A1: Basissignal
- A2: modifiziertes Antwortsignal
- V: Signalpegel
- I: Initialisierung
- PS: Prüfsequenz
- RS: Reset-Sequenz
- W: Wartezeit

## Patentansprüche

1. Verfahren zur Prüfung eines Kabelsatzes (4) mit einer Vielzahl von Leitungen mit Hilfe einer zentralen Prüfeinheit (8) und mit Hilfe von mehreren Prüfmodulen (6), über die entsprechend eines vorgegebenen Prüfprogramms (P) mehrere aufeinanderfolgende Prüfsequenzen (PS) durchgeführt werden, wobei die mehreren Prüfmodule (6) untereinander synchronisiert jeweils einen vorgegebenen Prüfschritt veranlassen, wobei an der Prüfeinheit (8) und den mehreren Prüfmodulen (6) ein Steuersignal (S, S1, S2) sowie zumindest ein Antwortsignal (A, A1, A2) anliegt, und wobei folgende Schritte durchgeführt werden:
a) Zum Starten einer Prüfsequenz (PS) wird von der Prüfeinheit (8) das Steuersignal als ein Startsignal (S1) bereitgestellt **,** so dass das Steuersignal (S1) an den Prüfmodulen (6) anliegt, über das die Prüfsequenz (PS) gestartet wird,
b) ein jedes Prüfmodul (6) veranlasst nach Erhalt des Startsignals (S1) eine Modifikation des zumindest einen Antwortsignals, so dass an der Prüfeinheit (8) ein modifiziertes Antwortsignal (A2) anliegt,
c) das jeweilige Prüfmodul (6) führt den ihm in der jeweiligen Prüfsequenz (PS) zugeordneten Prüfschritt durch,
d) das jeweilige Prüfmodul (6) veranlasst nach der Durchführung des zugeordneten Prüfschritts eine erneute Modifikation des Antwortsignals (A2),
e) die Prüfeinheit (8) überprüft das zumindest eine Antwortsignal (A, A1, A2) dahingehend, ob alle Prüfmodule (6) eine erneute Modifikation des Antwortsignals (A2) veranlasst haben,
f) die Prüfeinheit (8) wertet die Prüfsequenz (PS) als abgeschlossen, wenn alle Prüfmodule (6) das Antwortsignal (A2) erneut modifiziert haben,
g) die Prüfeinheit (8) startet nachfolgend vorzugsweise eine weitere Prüfsequenz (PS), wobei wieder gemäß den Schritten a) bis f) vorgegangen wird.

2. Verfahren nach dem vorhergehenden Anspruch, bei dem vor dem Schritt a) eine Initialisierung (I) veranlasst wird, insbesondere, indem das Steuersignal (S, S1, S2) sowie das Antwortsignal (A, A1, A2) bevorzugt durch die zentrale Prüfeinheit (8) angelegt wird.

3. Verfahren nach einem der beiden vorhergehenden Ansprüche, bei dem nach dem Schritt f) und vor dem Schritt g) eine Deinitialisierung durchgeführt wird, und hierzu die zentrale Prüfeinheit (8) ein Reset-Signal (S2) als Steuersignal abgibt und anschließend von den Prüfmodulen (6) die Deinitialisierung durchgeführt wird.

4. Verfahren nach dem vorhergehenden Anspruch, bei dem die Schritte b) bis f) bei der Deinitialisierung analog durchgeführt werden, wobei anstelle einer Prüfsequenz (PS) eine Reset-Sequenz (RS) mit geeigneten Schritten für die Deinitialisierung ausgeführt.

5. Verfahren nach dem vorhergehenden Anspruch, bei dem es sich bei dem Steuersignal (S, S1, S2) und / oder dem Antwortsignal (A, A1, A2) um ein digitales Signal handelt.

6. Verfahren nach dem vorhergehenden Anspruch, bei dem das Steuersignal (S, S1, S2) und / oder das Antwortsignal (A, A1, A2) lediglich zwischen zwei Signalpegeln wechselt, wobei unterschiedliche Signalzustände durch den momentanen Signalpegel definiert sind.

7. Verfahren nach einem der beiden vorhergehenden Ansprüche, bei dem das modifizierte Antwortsignal (A2) und das erneut modifizierte Antwortsignal (A1) durch unterschiedliche Signalpegel gebildet sind.

8. Verfahren nach einem der vorhergehenden Ansprüche, bei dem die Prüfeinheit (8) über eine Steuerleitung (22) sowie über zumindest eine Antwortleitung (18) und bevorzugt über genau eine Antwortleitung (18) mit den Prüfmodulen (6) verbunden ist, wobei über die Steuerleitung (22) das Steuersignal (S, S1, S2) und über die Antwortleitung (18) das Antwortsignal (A, A1, A2) bereitgestellt ist.

9. Verfahren nach einem der vorhergehenden Ansprüche, bei dem nur ein Antwortsignal (A, A1, A2) für alle Prüfmodule (6) sowie für die zentrale Prüfeinheit (8) bereitgestellt wird.

10. Verfahren nach einem der vorhergehenden Ansprüche, bei dem die Prüfmodule (6) bezüglich des Antwortsignals (A, A1, A2) seriell geschaltet sind und eine Antwortleitung (18), über die das Antwortsignal (A, A1, A2) an der zentralen Prüfeinheit (8) anliegt, von jedem der Prüfmodule (6) unterbrochen werden kann, wobei im Falle einer Unterbrechung das Antwortsignal (A, A1, A2) als modifiziertes Antwortsignal (A2) anliegt.

11. Verfahren nach einem der vorhergehenden Ansprüche, bei dem in einem ersten Schritt vor der ersten Prüfsequenz (PS) den Prüfmodulen (6) das Prüfprogramm (P) bekannt gemacht wird.

12. Verfahren nach dem vorhergehenden Anspruch, wobei die Prüfmodule (6) eine Steuereinheit (16) aufweisen, auf die das Prüfprogramm (P) als Steuerprogramm aufgespielt wird und die bevorzugt zur Ausführung der im Prüfprogramm (P) hinterlegten Schritte ausgebildet ist.

13. Verfahren nach einem der beiden vorhergehenden Ansprüche, bei dem das Prüfprogramm (P) den Prüfmodulen (6) von der zentralen Prüfeinheit (8) mitgeteilt wird.

14. Prüfvorrichtung zur Prüfung eines Kabelsatzes (4) mit einer Vielzahl von Leitungen mit Hilfe einer zentralen Prüfeinheit (8) und mit Hilfe von mehreren Prüfmodulen (6), über die entsprechend eines vorgegebenen Prüfprogramms (P) mehrere aufeinanderfolgende Prüfsequenzen (PS) durchgeführt werden, wobei die Prüfvorrichtung (2) dazu ausgebildet ist, dass die mehreren Prüfmodule (6) untereinander synchronisiert jeweils einen vorgegebenen Prüfschritt veranlassen, wobei an der Prüfeinheit (8) und den mehreren Prüfmodulen (6) ein Steuersignal (S, S1, S2) sowie zumindest ein Antwortsignal (A, A1, A2) anliegt, und wobei weiterhin die Prüfvorrichtung (2) zur Durchführung folgender Schritte ausgebildet ist:
a) Zum Starten einer Prüfsequenz (PS) wird von der Prüfeinheit (8) das Steuersignal als ein Startsignal (S1) bereitgestellt**,** so dass das Steuersignal (S1) an den Prüfmodulen (6) anliegt, über das die Prüfsequenz (PS) gestartet wird,
b) ein jedes Prüfmodul (6) veranlasst nach Erhalt des Startsignals (S1) eine Modifikation des zumindest einen Antwortsignals, so dass an der Prüfeinheit (8) ein modifiziertes Antwortsignal (A2) anliegt,
c) das jeweilige Prüfmodul (6) führt den ihm in der jeweiligen Prüfsequenz (PS) zugeordneten Prüfschritt durch,
d) das jeweilige Prüfmodul (6) veranlasst nach der Durchführung des zugeordneten Prüfschritts eine erneute Modifikation des Antwortsignals (A2),
e) die Prüfeinheit (8) überprüft das zumindest eine Antwortsignal (A, A1, A2) dahingehend, ob alle Prüfmodule (6) eine erneute Modifikation des Antwortsignals (A2) veranlasst haben,
f) die Prüfeinheit (8) wertet die Prüfsequenz (PS) als abgeschlossen, wenn alle Prüfmodule (6) das Antwortsignal (A2) erneut modifiziert haben,
g) die Prüfeinheit (8) startet nachfolgend vorzugsweise eine weitere Prüfsequenz (PS), wobei wieder gemäß den Schritten a) bis f) vorgegangen wird.

## Claims

1. A method for testing a cable set (4) with a plurality of conductors using a central test unit (8) and using several test modules (6), via which several successive test sequences (PS) are carried out according to a predetermined test program (P), wherein the several test modules (6) each initiate a predetermined test step in a mutually synchronized manner, wherein a control signal (S, S1, S2) and at least one response signal (A, A1, A2) are present at the test unit (8) and the several test modules (6), and wherein the following steps are carried out:
a) to start a test sequence (PS), the test unit (8) provides the control signal as a start signal (S1), such that the control signal (S1) is present at the test modules (6), via which the test sequence (PS) is started,
b) each test module (6), upon receiving the start signal (S1), initiates a modification of at least one response signal, such that a modified response signal (A2) is present at the test unit (8),
c) the respective test module (6) performs the test step, assigned to it in the respective test sequence (PS),
d) the respective test module (6) initiates a further modification of the response signal (A2) after the execution of the assigned test step,
e) the test unit (8) checks the at least one response signal (A, A1, A2) to see whether all test modules (6) have initiated a further modification of the response signal (A2),
f) the test unit (8) evaluates the test sequence (PS) as completed when all test modules (6) have modified the response signal (A2) again,
g) subsequently, the test unit (8) preferably starts another test sequence (PS), proceeding again in accordance with steps a) to f).

2. The method according to the preceding claim, wherein, before step a), an initialization (I) is initiated, in particular by applying the control signal (S, S1, S2) and the response signal (A, A1, A2) preferably by the central test unit (8).

3. The method according according to one of both preceding claims, wherein, after step f) and before step g), a deinitialization is performed and for this purpose the central test unit (8) outputs a reset signal (S2) as control signal and subsequently the deinitialization is performed by the test modules (6).

4. The method according according to the preceding claim, wherein the steps b) to f) are performed analogously during deinitialization, wherein, instead of a test sequence (PS), a reset sequence (RS) with suitable steps for deinitialization is performed.

5. The method according according to the preceding claim, wherein the control signal (S, S1, S2) and/or the response signal (A, A1, A2) is a digital signal.

6. The method according according to the preceding claim, wherein the control signal (S, S1, S2) and/or the response signal (A, A1, A2) merely alternates between two signal levels, wherein different signal states are defined by the instantaneous signal level.

7. The method according according to one of both preceding claims, wherein the modified response signal (A2) and the again modified response signal (A1) are formed by different signal levels.

8. The method according according to any one of the preceding claims, wherein the test unit (8) is connected to the test modules (6) via a control line (22) and via at least one response line (18) and preferably via exactly one response line (18), wherein the control signal (S, S1, S2) is provided via the control line (22) and the response signal (A, A1, A2) is provided via the response line (18).

9. The method according according to any one of the preceding claims, wherein only one response signal (A, A1, A2) for all test modules (6) as well as for the central test unit (8) is provided.

10. The method according according to any one of the preceding claims, wherein the test modules (6) are connected in series with respect to the response signal (A, A1, A2) and a response line (18), via which the response signal (A, A1, A2) is present at the central test unit (8), can be interrupted by each of the test modules (6), wherein, in the event of an interruption, the response signal (A, A1, A2) is present as a modified response signal (A2).

11. The method according according to any one of the preceding claims, wherein, in a first step before the first test sequence (PS), the test program (P) is made known to the test modules (6).

12. The method according according to the preceding claim, wherein the test modules (6) have a control unit (16) onto which the test program (P) is uploaded as a control program and which is preferably configured to execute the steps stored in the test program (P).

13. The method according according to one of both preceding claims, wherein the test program (P) is communicated to the test modules (6) by the central test unit (8).

14. A test device for testing a cable set (4) with a plurality of conductors using a central test unit (8) and using several test modules (6), via which several successive test sequences (PS) are carried out according to a predetermined test program (P), wherein the test device (2) is configured such that the several test modules (6) each initiate a predetermined test step in a mutually synchronized manner, wherein a control signal (S, S1, S2) and at least one response signal (A, A1, A2) are present at the test unit (8) and the several test modules (6), and wherein the test device (2) is further configured to carry out the following steps:
a) to start a test sequence (PS), the test unit (8) provides the control signal as a start signal (S1), such that the control signal (S1) is present at the test modules (6), via which the test sequence (PS) is started,
b) each test module (6), upon receiving the start signal (S1), initiates a modification of at least one response signal, such that a modified response signal (A2) is present at the test unit (8),
c) the respective test module (6) performs the test step, assigned to it in the respective test sequence (PS),
d) the respective test module (6) initiates a further modification of the response signal (A2) after the execution of the assigned test step,
e) the test unit (8) checks the at least one response signal (A, A1, A2) to see whether all test modules (6) have initiated a further modification of the response signal (A2),
f) the test unit (8) evaluates the test sequence (PS) as completed when all test modules (6) have modified the response signal (A2) again,
g) subsequently, the test unit (8) preferably starts another test sequence (PS), proceeding again in accordance with steps a) to f).

## Revendications

1. Procédé pour le contrôle d'un faisceau de câbles (4) comportant une pluralité de conducteurs, à l'aide d'une unité de contrôle centrale (8) et à l'aide de plusieurs modules de contrôle (6), par l'intermédiaire desquels plusieurs séquences de contrôle (PS) successives sont exécutées conformément à un programme de contrôle (P) préétabli, procédé dans lequel lesdits plusieurs modules de contrôle (6) déclenchent chacun, en étant synchronisés entre eux, une étape de contrôle préétablie, dans lequel un signal de commande (S, S1, S2) ainsi qu'au moins un signal de réponse (A, A1, A2) sont présents sur l'unité de contrôle (8) et lesdits plusieurs modules de contrôle (6), et dans lequel les étapes suivantes sont exécutées :
a) pour le démarrage d'une séquence de contrôle (PS), le signal de commande est fourni sous forme d'un signal de démarrage (S1) par l'unité de contrôle (8), de sorte que le signal de commande (S1) est présent sur les modules de contrôle (6), par l'intermédiaire duquel la séquence de contrôle (PS) est démarrée,
b) chaque module de contrôle (6) déclenche, après réception du signal de démarrage (S1), une modification dudit au moins un signal de réponse, de sorte qu'un signal de réponse modifié (A2) est présent sur l'unité de contrôle (8),
c) le module de contrôle respectif (6) exécute l'étape de contrôle qui lui est affectée dans la séquence de contrôle (PS) respective,
d) après l'exécution de l'étape de contrôle affectée, le module de contrôle (6) respectif déclenche une nouvelle modification du signal de réponse (A2),
e) l'unité de contrôle (8) vérifie ledit au moins un signal de réponse (A, A1, A2), pour déterminer si tous les modules de contrôle (6) ont déclenché une nouvelle modification du signal de réponse (A2),
f) l'unité de contrôle (8) considère que la séquence de contrôle (PS) est terminée lorsque tous les modules de contrôle (6) ont à nouveau modifié le signal de réponse (A2),
g) l'unité de contrôle (8) démarre ensuite de préférence une nouvelle séquence de contrôle (PS), en procédant de nouveau conformément aux étapes a) à f).

2. Procédé selon la revendication précédente, dans lequel avant l'étape a) une initialisation (1) est déclenchée, en particulier, par l'application du signal de commande (S, S1, S2) ainsi que du signal de réponse (A, A1, A2), de préférence par l'unité de contrôle centrale (8).

3. Procédé selon l'une quelconque des deux revendications précédentes, dans lequel une désinitialisation est effectuée après l'étape f) et avant l'étape g), et à cette fin l'unité de contrôle centrale (8) émet un signal de remise à l'état initial (S2) en tant que signal de commande et la désinitialisation est ensuite effectuée par les modules de contrôle (6).

4. Procédé selon la revendication précédente, dans lequel les étapes b) à f) sont effectuées de manière analogue lors de la désinitialisation, une séquence de remise à l'état initial (RS) comportant des étapes appropriées pour la désinitialisation étant exécutée au lieu d'une séquence de contrôle (PS).

5. Procédé selon la revendication précédente, dans lequel pour ce qui est du signal de commande (S, S1, S2) et/ou du signal de réponse (A, A1, A2) il s'agit d'un signal numérique.

6. Procédé selon la revendication précédente, dans lequel le signal de commande (S, S1, S2) et/ou le signal de réponse (A, A1, A2) ne varie(nt) qu'entre deux niveaux de signal, les différents états de signal étant définis par le niveau de signal à l'instant considéré.

7. Procédé selon l'une quelconque des deux revendications précédentes, dans lequel le signal de réponse modifié (A2) et le signal de réponse à nouveau modifié (A1) sont constitués par des niveaux de signal différents.

8. Procédé selon l'une quelconque des revendications précédentes, dans lequel l'unité de contrôle (8) est reliée aux modules de contrôle (6) par l'intermédiaire d'une ligne de commande (22) ainsi que par l'intermédiaire d'au moins une ligne de réponse (18) et de préférence par l'intermédiaire d'exactement une ligne de réponse (18), le signal de commande (S, S1, S2) étant fourni par l'intermédiaire de la ligne de commande (22) et le signal de réponse (A, A1, A2) étant fourni par l'intermédiaire de la ligne de réponse (18).

9. Procédé selon l'une quelconque des revendications précédentes, dans lequel un seul signal de réponse (A, A1, A2) est fourni pour tous les modules de contrôle (6) ainsi que pour l'unité de contrôle centrale (8).

10. Procédé selon l'une quelconque des revendications précédentes, dans lequel les modules de contrôle (6) sont connectés en série en ce qui concerne le signal de réponse (A, A1, A2) et une ligne de réponse (18), par l'intermédiaire de laquelle le signal de réponse (A, A1, A2) est présent sur l'unité de contrôle centrale (8), peut être interrompue par chacun des modules de contrôle (6), dans le cas d'une interruption le signal de réponse (A, A1, A2) étant présent sous forme de signal de réponse modifié (A2).

11. Procédé selon l'une quelconque des revendications précédentes, dans lequel, dans une première étape précédant la première séquence de contrôle (PS), le programme de contrôle (P) est communiqué aux modules de contrôle (6).

12. Procédé selon la revendication précédente, dans lequel les modules de contrôle (6) comportent une unité de commande (16) sur laquelle le programme de contrôle (P) est chargé en tant que programme de commande et qui est conçue de préférence pour l'exécution des étapes enregistrées dans le programme de contrôle (P).

13. Procédé selon l'une quelconque des deux revendications précédentes, dans lequel le programme de contrôle (P) est transmis aux modules de contrôle (6) par l'unité de contrôle centrale (8).

14. Dispositif de contrôle destiné au contrôle d'un faisceau de câbles (4) comportant une pluralité de conducteurs, à l'aide d'une unité de contrôle centrale (8) et à l'aide de plusieurs modules de contrôle (6), par l'intermédiaire desquels plusieurs séquences de contrôle (PS) successives sont exécutées conformément à un programme de contrôle (P) préétabli, le dispositif de contrôle (2) étant configuré de façon telle que lesdits plusieurs modules de contrôle (6) déclenchent chacun, en étant synchronisés entre eux, une étape de contrôle préétablie, un signal de commande (S, S1, S2) ainsi qu'au moins un signal de réponse (A, A1, A2) étant présents sur l'unité de contrôle (8) et sur lesdits plusieurs modules de contrôle (6), et le dispositif de contrôle étant en outre configuré pour l'exécution des étapes suivantes :
a) pour le démarrage d'une séquence de contrôle (PS), le signal de commande est fourni sous forme d'un signal de démarrage (S1) par l'unité de contrôle (8) de sorte que le signal de commande (S1) est présent sur les modules de contrôle (6), par l'intermédiaire duquel la séquence de contrôle (PS) est démarrée,
b) chaque module de contrôle (6) déclenche, après réception du signal de démarrage (S1), une modification dudit au moins un signal de réponse, de sorte qu'un signal de réponse modifié (A2) est présent sur l'unité de contrôle (8),
c) le module de contrôle respectif (6) exécute l'étape de contrôle qui lui est affectée dans la séquence de contrôle (PS) respective,
d) après l'exécution de l'étape de contrôle affectée, le module de contrôle (6) respectif déclenche une nouvelle modification du signal de réponse (A2),
e) l'unité de contrôle (8) vérifie ledit au moins un signal de réponse (A, A1, A2), pour déterminer si tous les modules de contrôle (6) ont déclenché une nouvelle modification du signal de réponse (A2),
f) l'unité de contrôle (8) considère que la séquence de contrôle (PS) est terminée lorsque tous les modules de contrôle (6) ont à nouveau modifié le signal de réponse (A2),
g) l'unité de contrôle (8) démarre ensuite de préférence une nouvelle séquence de contrôle (PS), en procédant de nouveau conformément aux étapes a) à f).
